(19) Europäisches Patentamt
European Patent Office
Office européen des brevets

(11) Publication number : **0 394 924 B1**

(12) **EUROPEAN PATENT SPECIFICATION**

(45) Date of publication of patent specification :
**12.07.95 Bulletin 95/28**

(51) Int. Cl.$^6$ : **G03F 7/075,** G03F 7/11

(21) Application number : **90107663.8**

(22) Date of filing : **23.04.90**

# (54) Photosensitive lithographic printing plate requiring no wetting water.

(30) Priority : **24.04.89 JP 104287/89**

(43) Date of publication of application :
**31.10.90 Bulletin 90/44**

(45) Publication of the grant of the patent :
**12.07.95 Bulletin 95/28**

(84) Designated Contracting States :
**DE FR GB**

(56) References cited :
**EP-A- 0 242 143**
**DE-A- 3 816 211**
**PATENT ABSTRACTS OF JAPAN vol. 10, no. 93 (P-445)(2150) 10 April 1986, & JP-A-60 229031**

(73) Proprietor : **Mitsubishi Chemical Corporation**
**5-2, Marunouchi 2-chome**
**Chiyoda-ku Tokyo (JP)**
Proprietor : **KONICA CORPORATION**
**26-2, Nishishinjuku 1-chome,**
**Shinjuku-ku**
**Tokyo 160 (JP)**

(72) Inventor : **Tomiyasu, Hiroshi**
**205 Daiya Paresu Tama-center,**
**2-25 Minamino 3chome**
**Tama-shi, Tokyo (JP)**
Inventor : **Kasakura, Akeo**
**Onda-ryo,**
**23-4 Tana-cho,**
**Midori-ku**
**Yokohama-shi, Kanagawa-ken (JP)**
Inventor : **Suzuki, Norihito**
**35-4 Kinugaoka 1-chome**
**Hachioji-shi, Tokyo (JP)**
Inventor : **Nakajima, Akihisa**
**Konica Owada-ryo, 5-19 Owado-cho 2-chome**
**Hachioji-shi, Tokyo (JP)**

(74) Representative : **TER MEER - MÜLLER - STEINMEISTER & PARTNER**
**Mauerkircherstrasse 45**
**D-81679 München (DE)**

**EP 0 394 924 B1**

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to a photosensitive lithographic printing plate, more particularly, a photosensitive lithographic printing plate which comprises a support and a primer layer, a photosensitive layer and a silicone rubber layer applied on the surface of the support in this order and does not require wetting water in printing.

In the lithography, printing is effected based on delicate balance of ink and water created by lipophilicity of the image portion and hydrophilicity of the non-image portion, wherein considerable skill is required.

In the printing system in which wetting water is required, printing plates are prepared by exposing a plate which comprises a hydrophilic support and a lipophilic photosensitive layer provided on the former to light through an image film and developing the plate so as to form the lipophilic image portion and the hydrophilic non-image portion. In printing, the non-image portion is wetted and printing ink is applied on the image portion. The ink adheres to the image portion only and not to the wetted non-image portion. In this printing system, however, the control of delicate balancing of the wetting water and the printing ink is difficult and often emulsification of ink or immigration of ink to the non-image portion occurs causing insufficiency in ink density or staining of the non-image portion, and wastes paper.

There is also a problem that the wetting water is transferred to printing paper, which causes dimensional change of paper inviting difficulty especially in multicolor printing.

Therefore, development of lithographic printing plate which does not require the wetting water (hereinafter, we call it "waterless lithographic plate" in places) has been attempted. Japanese Patent Publication Nos. 44-23042 and 46-16044 disclose waterless lithographic plates which comprise a support, a photosensitive layer and a silicone rubber layer provided on the photosensitive layer, and processes for preparing a printing plate wherein the silicone rubber layer is removed when the plate is developed and the photosensitive layer is dissolved by a developer. Japanese Patent Publication Nos. 56-26923 and 54-23150 disclose similar lithographic plates which comprise a support, a photosensitive layer and a silicone rubber layer and processes for preparing a lithographic printing plate, wherein the photosensitive layer is not dissolved but photochemical adhesion or photochemical separation of the photosensitive layer and the silicone rubber layer is caused and thus the silicone rubber layer is selectively swelled and removed.

Further, Japanese Patent Publication No. 61-54219, Japanese Laid-Open Patent Publication Nos. 60-229031 and 62-194255 disclose waterless lithographic printing plates which comprise a support, a primer layer, a photosensitive layer and a silicone rubber layer.

In the processes disclosed in said Japanese Patent Publications Nos. 44-23042 and 46-16044, there is a problem that the image portion is rather deeply cleared in developing and, therefore, the printing ink must be thickly applied in order to sufficiently cover the image portion, although adhesion between the silicone rubber layer and the photosensitive layer and between the support and the photosensitive layer is enhanced and image quality, durability and scratch resistance are improved. Also in the processes disclosed in said Japanese Patent Publication Nos. 54-26923 and 56-23150, the designing of the silicone rubber layer is difficult because delicate adhesion of the silicone rubber layer and the photosensitive layer is relied upon, and, therefore, the obtained printing plate is not satisfactory in the scratch resistance and reproducibility of the image, although the above-described difficulty in the ink application can be obviated.

Further in the process disclosed in said Japanese Laid-Open Patent Publication No. 60-229031, there is a defect that the dyeability of the primer layer is poor and the adhesion of the photosensitive layer and the primer layer is not sufficient, although the above-described defects are overcome. In the processes of Japanese Patent Publication No. 61-54219 and Japanese Laid-Open Patent Publication No. 62-194255, the primer layer is heat-crosslinkable and is thermally cured after it has been applied on the surface of a support and, therefore, the process is inferior in productivity and economically disadvantageous.

The object of the present invention is to provide a photosensitive lithographic printing plate which does not require wetting water. Particularly, it is to provide a photosensitive lithographic printing plate excellent in the dyeability and the adhesion of the primer layer and the photosensitive layer and the support which does not require wetting water.

In order to solve the above problems, we carried out an intensive study and have found that the above-mentioned object can be achieved by a photosensitive lithographic printing plate which comprises a support and at least a primer layer, a photosensitive layer and a silicone rubber layer provided on the support in this order, said primer layer containing a diazo resin and a polymer containing hydroxyl groups and having been photochemically cured before the photosensitive layer is applied, said photosensitive lithographic printing plate requiring no wetting water.

Now the invention will be more specifically described.

The primer layer used in the present invention contains a diazo resin and a polymer containing hydroxyl groups as an essential components and has been photochemically cured before the photosensitive layer is

applied.

As the above-mentioned diazo resin, a diazo resin obtained by condensation of a diazo compound and an active carbonyl compound (such as formaldehyde, acetoaldehyde or benzaldehyde) in an acidic solvent such as sulfuric acid, phosphoric acid, hydrochloric acid, etc. as described in page 33 of Vol. 17 (1973) of "Photographic Science and Engineering", U.S. Patent Nos. 2,063,631; 2,679,498; 3,050,502; Japanese Laid-Open Patent Publication No. 59-78340, etc.; a diazo resin obtained by condensation of a diazo compound and a diphenylether derivative as described in Japanese Patent Publication No. 49-4001, etc. can be used.

The counter anions of the diazo resin usable in the present invention include anions which form stable salts with said diazo resin and that makes said resin soluble in organic solvents. These include organic carboxylic acids such as decanoic acid, benzoic acid, etc.; organic phosphoric acid such as phenylphosphoric acid, sulfonic acid, etc. Typical examples are, aliphatic and aromatic sulfonic acids such as methanesulfonic acid, chloroethanesulfonic acid, dodecanesulfonic acid, benzenesulfonic acid, toluenesulfonic acid, mesitylenesulfonic acid, anthraquinonesulfonic acid, 2-hydroxy-4-methoxybenzophenone-5-sulfonic acid, hydroquinone sulfonic acid, 4-acetylbenzenesulfonic acid, dimethyl-5-sulfo-isophthalates, etc.; hydroxyl-containing aromatic compounds such as 2,2′,4,4′-tetrahydroxybenzophenone; 1,2,3-trihydroxybenzophenone; 2,2′,4-trihydroxybenzophenone, etc.; perhalogenated Lewis acids such as hexafluorophosphoric acid, tetrafluoroboric acid, etc.; perhalogenic acids such as $HClO_4$, $HIO_4$, etc., although they are not limited thereto. The diazo resins having a weight average molecular weight of 200-10000, preferably 500-5000 with styrene as reference, measured by the gel permeation chromatography (GPC) of a coupling product with β-naphthol.

In the present invention, the primer layer, usually contains 1-90 wt.%, preferably 3-60 wt.% of the above-described diazo resin.

In the present invention, polymers of an ester or amide of a polyacrylic acid containing hydroxyl groups, polyvinyl alcohol derivatives, epoxy resins, novolak resins, gelatin, cellulose, etc. can be used as hydroxyl-containing polymers. But polymers having alcoholic hydroxyl groups are preferred from the viewpoint of dyeability and adhesion.

Examples of the usable monomers containing alcoholic hydroxyl groups are 2-hydroxyethyl acrylate, 2-hydroxyethyl methacrylate, N-(4-hydroxyethylphenyl) methacrylamide, hydroxymethyldiacetone (meth)acrylamide, etc.

Examples of the monomers copolymerizable with the above-mentioned hydroxyl-containing monomer are:

(1) aromatic hydroxyl-containing monomers such as N-(4-hydroxyphenyl)acrylamide, N-(4-hydroxyphenyl)methacrylamide, N-(4-hydroxyphenyl)methacrylamide; o-, m- or p-hydroxystyrene; o-, m- or p-hydroxyphenyl acrylate or methacrylate;

(2) α-β unsaturated carboxylic acids such as acrylic acid, methacrylic acid, maleic anhydride, etc;

(3) (substituted) alkyl acrylates such as methyl acrylate ,ethyl acrylate, propyl acrylate, butyl acrylate, amyl acrylate, hexyl acrylate, octyl acrylate, 2-chloroethyl acrylate 2-hydroxyethyl acrylate, glycidyl acrylate, N-dimethylaminoethyl acrylate, etc.;

(4) (substituted) alkyl methacrylates such as methyl methacrylate, ethyl methacrylate, propyl methacrylate, butyl methacrylate, amyl methacrylate, cyclohexyl methacrylate, 2-hydroxyethyl methacrylate, 4-hydroxybutyl methacrylate, glycidyl methacrylate, N-dimethylaminoethyl methacrylate, etc.;

(5) acrylamides or methacrylamides such as acrylamide methacrylamide, N-methylolacrylamide, N-ethylacrylamide, N-hexylmethacrylamide, N-cyclohexylacrylamide, N-hydrohexyethylacrylamide, N-phenylacrylamide, N-nitrophenylacrylamide, N-ethyl-N-phenylacrylamide, etc.;

(6) vinyl ethers such as ethylvinylether, 2-chloroethyl vinylether, hydroxyethylvinylether, propylvinylether, butylvinylether, octylvinylether, phenylvinylether, etc.;

(7) vinyl esters such as vinyl acetate, vinyl chloroacetate, vinyl butyrate, vinyl benzoate, etc.;

(8) styrenes such as styrene, α-methylstyrene, chlorostyrene, etc.;

(9) vinyl ketones such as methylvinyl ketone, ethylvinyl ketone, propylvinyl ketone, phenylvinyl ketone, etc.;

(10) olefins such as ethylene, propylene, isobutylene, butadiene, isobutylene, etc.;

(11) N-vinylpyrrolidone, N-vinylcarbazol, 4-vinylpyridine, acrylonitrile, methacrylonitrile, etc.

The hydroxyl group content of the above-described monomer containing a hydroxyl group is not specifically limited, although it is preferably 5-100 wt.% and more preferably 20-100 wt.%.

The weight average molecular weight of the hydroxyl-containing polymer in accordance with the present invention measured by the GPC with styrene as reference should preferably be 5,000-1,000,000. If the molecular weight is less than 5,000, the photosensitive layer after exposure to light may still be attacked by the solvent or the developing solution and, if the molecular weight is more than 1,000,000, the usable solvent is limited.

The content of the above-described hydroxyl-containing polymer in the primer layer is usually 10-99 wt.% and preferably 40-97 wt.%.

The weight content ratio of the diazo resin and the hydroxyl-containing polymer should preferably be 1/99 - 90/10.

If the diazo resin content is less than 1/99, the light-exposed resin is not sufficiently crosslinked and thus may be attacked by the solvent or a developing solution. On the other hand, when the diazo resin content is more than 90/10, the polymer content is small, i.e., the hydroxyl content is small and thus the primer layer becomes less dyeable.

The primer layer in accordance with the present invention may contain a filler such as titanium oxide, a halation preventor, a colorant such as a dye, a pigment, an applicability-improver, a plasticizer, a stabilizer, an oleophilizer, etc. in an amount of not more than 10 wt.% in addition to the above-described essential ingredients.

Examples of the dyes usable for the primer layer are triphenylmethane, diphenylmethane, oxazine, xanthene, iminonaphthoquinone, azomethine or anthraquinone dyes such as victoria pure blue BOH, oil blue #603, oil pink #312, patent pure blue, crystal violet, leucocrystal violet, brilliant green, ethyl violet, methyl green, erythrosine B, basic fuchsin, malachite green, leucomalachite green, m-cresol purple, cresol red, xylenol blue, rhodamine B, auramine, 4-p-diethylaminophenyliminonaphthoquinone, cyano-p-diethylaminophenylacetoanilide, etc.

Examples of the applicability-improver are an alkylether such as ethyl cellulose, methyl cellulose, etc., fluorine-containing surfactants, nonionic surfactants such as Pluronic L-64 (marketed by Asahi Denka K.K.), FC-430 (marketed by Sumitomo 3M K.K.), etc.

Examples of the plasticizers, which provide flexibility, abrasion resistance, etc., are butyl phthalate, polyethylene glycol, tributyl citrate, diethyl phthalate, dibutyl phthalate, dihexyl phthalate, dioctyl phthalate, tricresyl phosphate, tributyl phosphate, trioctyl phosphate, tetrahydrofurfuryl oleate, oligomers of acrylic or methacrylic acid, etc.

In order to improve affinity of the image portion to printing ink, various additives having hydrophobic groups including modified novolak resins such as p-octylphenol-formalin novolak resin, p-t-butylphenol-formalin novolak resin, p-t-butylphenol-benzaldehyde resin, etc., and o-naphthoquinonediazide sulfonic acid esters (the esterification rate of the OH groups is 20-70 mol%) of these modified novolak resins can be added.

The primer layer is formed by dissolving the above-described photo-curable diazo resin and a hydroxyl-containing polymer in a suitable solvent together with other additives as desired, applying the solution on the support, drying, exposing to light so as to completely decompose the diazo resin and hardening.

The curing of the above-described primer layer can be effected by exposing the primer layer to a known light source such as a mercury lamp, a xenon lamp, natural light, etc. to an extent sufficient for hardening the layer (usually in a range of 50 $mJ/cm^2$ - 5 $J/cm^2$).

The exposure should preferably be effected before the application of a photosensitive layer is finished.

Any photosensitive layer can be employed to be provided on the above-described primer layer in the present invention, if its solubility in a developer changes after the exposure.

Specific examples thereof are photo-solubilizable photosensitive layers containing an o-quinonediazide compound, o-nitrobenzylcarbinol ester compound, or the like, photo-insolubilizable photosensitive layers containing diazo compounds, compounds having addition-polymerizable vinyl groups or the like.

The o-quinonediazido compounds have at least one o-quinonediazide group, preferably o-benzoquinonediazide or o-naphthoquinonediazide. They encompass many known compounds such as described in "Light-Sensitive Systems" by J. Kosar published by John Wiley and Sons, Inc., 1965, p. 339-353. Specific examples are esters of various hydroxyl compounds and benzoquinone-1,2-diazidosulfonic acid, naphthoquinone-1,2-diazidosulfonic acid, etc. Examples of said hydroxyl compounds are condensation resins of a phenol such as phenol, cresol and pyrogallol, etc. and a carbonyl-containing compound such as formaldehyde, benzaldehyde and acetone, especially those resins which are condensed in the presence of an acid catalyst.

Preferred examples of the photosensitive layer containing a diazo compound are photosensitive layers which contain diazo resins similar to those contained in the above-described primer layer. The content of the diazo resin in the photosensitive layer is preferably 1-90 wt.%, and more preferably 3-60 wt.%.

Examples of compounds having addition-polymerizable vinyl groups are compounds which have two or more polymerizable terminal ethylene groups and exhibit a boiling point of 100°C or higher at normal pressure such as unsaturated carboxylic acids, esters of an unsaturated carboxylic acid and an aliphatic polyhydroxy compound, esters of an unsaturated carboxylic acid and an aromatic polyhydroxy compound, esterification products of an unsaturated carboxylic acid and a polybasic carboxylic acid, the above-mentioned aliphatic polyhydroxy compound, aromatic polyhydroxy compound or the like, etc. Specific compounds are described in Japanese Laid-Open Patent Publication No. 59-71048.

Although all of the above-described photosensitive layers can be employed, photosensitive layers containing diazo resin are preferable from the viewpoint of adhesion to the primer layer.

The photosensitive layer in the present invention may further contain a dye, a pigment, a known visiblizer-upon-exposure, an applicability-improver, etc. in addition to the above-described components in order to improve visibility-upon-development, visibility-upon-exposure and applicability.

In the present invention, the photosensitive layer should preferably contain a hydroxyl-containing polymer. The same or similar hydroxyl-containing polymers as described above with respect to the primer layer can be used.

The thickness of the photosensitive layer is preferably 0.1 mg/dm$^2$ - 30 mg/dm$^2$ and more preferably 0.5 mg/dm$^2$ - 10 mg/dm$^2$.

In the present invention, a silicone rubber layer is provided on the above-described photosensitive layer. Linear or somewhat crosslinked organopolysiloxanes are preferably used as a silicone rubber. Said organopolysiloxanes have a molecular weight of several thousand to several hundred thousand and are liquid and wax-like or jelly-like with a suitable consistency if they are crosslinked to some extent. Crosslinking of said organosiloxanes is either of condensation type or of addition type.

Condensation type crosslinking is effected by a condensation reaction, wherein water, alcohol, organic acid, etc. are liberated. A mixture of a linear organopolysiloxane, which has hydroxyl groups at both ends or in a part of the main chain, and a silicone crosslinking agent and the reaction product of the two are especially useful. In either case, a condensation catalyst is preferably added.

The main chain of said organopolysiloxanes comprises the repeating unit

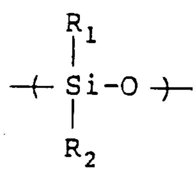

wherein $R_1$ and $R_2$ are respectively an alkyl, aryl or alkenyl group which may have substituents such as cyano, halogen, hydroxyl, etc. or combination thereof. Methyl, phenyl, vinyl and trifluoropropyl are preferred and methyl is most preferred.

Said silicone crosslinking agents are deacetation type, deoximation type, dealcoholization type, deamination type, or dehydration type condensation silicone crosslinking agents, which contain functional groups represented by

$-OCOCH_3$ , 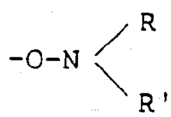 , 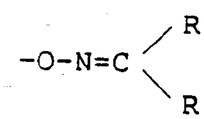 , $-OR$ , 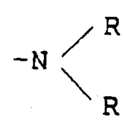 or $-OH$ ,

wherein R and R′ stand for alkyls. Specific examples thereof are tetraacetoxysilane, methyltriacetoxysilane, ethyltriacetoxysilane, phenyltriacetoxysilane, dimethylacetoxysilane, diethylacetoxysilane, vinyltriacetoxysilane, methyltrimethoxysilane, dimethyldimethoxysilane, vinyltrimethoxysilane, methyl-tris-(acetonoxime)silane, methyl-tri(N-methyl-N-acetylamino)silane, vinyl-tri(methylethylketoxime)silane, methyl-tri(methylethylketoxime)silane, oligomers thereof, etc.

The crosslinking agent is preferably used in an amount of 0.5-30 parts by weight per 100 parts by weight of organopolysiloxane.

Examples of the above-mentioned condensation catalysts are organic carboxylic acids, titanate esters, naphthenic acid, etc.

The term "addition type condensation catalyst" means those of which hydroxyl groups adds to unsaturated groups such as the vinyl($-CH=CH_2$) group in the organopolysiloxane.

Specific examples are a mixture of a vinyl-containing organopolysiloxane, hydrogenated organopolysiloxane, etc. and a platinum catalyst (chloroplatinic acid, for instance), etc.

Said organopolysiloxanes have the same repeating units as described above with respect to that of the condensation type in the main chain.

Either of condensation type silicone rubber and addition type silicone rubber or both can be used as the silicone rubber layer in the present invention.

Organopolysiloxanes which have both hydroxyl groups and unsaturated groups and are of both condensation type and addition type can also be used.

Of the commercially available silicone rubbers usable in the present invention, preferred are condensation type silicone rubbers such as KS-705F; KE-41, 42 and 44 supplied by Shin'etsu Kagaku K.K.; YE5505, YF3057, supplied by Toshiba Silicone K.K.; SH-781, PRX-305, SH-237 supplied by Toray Silicone K.K.; etc. and addition type silicone rubbers KS-837, KE-103, KE-106, KE-1300 supplied by Toshiba Silicone; TSE-3032, RTU-B supplied by Toshiba Silicone K.K.; SH-9555 supplied by Toray Silicone K.K., etc.

Inorganic fillers such as silica, titanium oxide, aluminum oxide, etc. can be used in order to improve the strength of silicone rubber. Silica is preferred. Fillers having average particle diameter of not larger than 500 nm are preferred from the viewpoint of dispersibility and dispersion stability.

The thickness of the silicone rubber layer in the present invention should preferably be as small as possible from the viewpoints of image quality and developability. From the viewpoint of printing durability and resistance to staining, however, some extent of thickness is required. Therefore, 3 $mg/dm^2$ - 50 $mg/dm^2$ is preferable and 5 $mg/dm^2$ - 30 $mg/dm^2$ is more preferable.

An adhesive layer of an epoxy resin, for instance, can be provided between the photosensitive layer and the silicone rubber layer. Various kinds of reactive crosslinking agent, silane couplers, etc. can be used for the adhesive layer. The thickness of the adhesive layer should preferably be 0.1 $mg/dm^2$ - 5 $mg/dm^2$.

In the waterless lithographic printing plate of the present invention, a protective layer may be provided on the surface of the silicone rubber layer. Such a protective layer can be provided by laminating a polypropylene film as disclosed in Japanese Laid-Open Patent Publication No. 61-614 or applying a high polymer as disclosed in Japanese Laid-Open Patent Publication No. 61-27545.

Any support plates which can be set on ordinary lithographic printing apparatuses and have satisfactory flexural rigidity to bear the load in printing can be used in the present invention, and are not specifically limited in material and structure. Paper such as coated paper, metal plates such as aluminum plate, sheets of plastics such as polyethylene terephthalate, etc. are used.

However, aluminum plate or composite material including aluminum foil is preferable and aluminum plate is most preferred from the viewpoint of printing durability.

In the present invention, the surface of aluminum plates and aluminum foils are preferably roughened, anodized and further treated with a silicate salt. The silicate treatment is carried out by soaking aluminum plates in a 0.1-10% sodium silicate aqueous solution for 1 sec. - 2 min. at 30-95°C, preferably for 10 sec. - 2 min. at 40-95°C.

The thus prepared photosensitive lithographic printing plate is imagewise exposed and developed with a developer so as to remove the developed portion of the photosensitive layer together with the silicone rubber layer. Thus the support and the primer layer appear as the image portion and thus a waterless lithographic printing plate is obtained.

The image portion will preferably be dyed during or after developing with a cathionic dye such as crystal violet, victorian blue BOH, etc.

Any light sources which emit ultraviolet rays and visible rays having a wavelength of not less than 180 nm can be used for exposure although a carbon arc light, a mercury lamp, a xenon lamp, a metal halide lamp and strobo light are suitable.

The developer for developing the photosensitive layer is an aqueous solution containing a polar solvent, an alkaline compound such as an amine, a surfactant, and further an aliphatic hydrocarbon (hexane, heptane, "Isopar E.E.G." supplied by Esso Chemical Company, gasoline, kerosene, etc.), an aromatic hydrocarbon (toluene, xylene, etc.) or a halogenated hydrocarbon (triclene, etc.) as desired.

Polar Solvents

Alcohols such as methanol, ethanol, water, etc.

Ethers such as methyl cellosolve, ethyl cellosolve, butyl cellosolve, methyl carbitol, ethyl carbitol, butyl carbitol, dioxane, etc.

Ketones such as acetone, methylethylketone, etc.

Esters such as ethyl acetate, methyl cellosolve acetate, cellosolve acetate, carbitol acetate, etc.

Developing can be effected by any known procedure such as rubbing the plate with a developing pad containing a developer as described above, pouring the developer on the surface of the printing plate and, thereafter, rubbing with a developing brush.

Now the invention will be illustrated in detail by way of working examples, although the invention is not limited thereto.

[Synthesis of Diazo Resin No. 1]

Under the ice-cooled condition, 14.5 g of p-diazophenylamine sulfate was dissolved in 40.9 g of concentrated sulfuric acid. To this solution, 1.0 g of paraformaldehyde was slowly added so that the temperature would not exceed 10°C. The reaction mixture was further stirred under the ice-cooled condition for 2 hours. Thereafter, the reaction mixture was dropped into 500 ml of ethanol. The formed precipitate was collected by filtration, and washed with ethanol. The thus obtained precipitate was dissolved in 100 ml of pure water, and a cold thick solution containing 6.8 g of zinc chloride was added. The formed precipitate was collected by filtration, washed with ethanol and dissolved in 150 ml of pure water. To this solution, a cold concentrated solution containing 8 g of hexafluorophosphoric acid ammonium was added. The formed precipitate was collected by filtration, washed and dried at 30°C for 24 hours. Thus Diazo Resin No. 1 was obtained.

The weight average molecular weight Mw of the Diazo Resin No. 1 measured with respect to a coupling product with β-naphthol by the GPC process was 1500 with styrene as reference. The number average molecular weight was 500.

[Synthesis of Polymer No. 1]

To 700 g of the rectified dioxane, 150 g of 2-hydroxyethyl methacrylate, 60 g of acrylonitrile, 79.5 g of methyl methacrylate and 10.5 g of methacrylic acid (37:35:24:4 in the molar ratio) were added (the total monomer concentration was 4.6 moles/ℓ), and to the resulting solution, 15 g (2 mol.%) of benzoyl peroxide was slowly added to allow polymerization under refluxing in a nitrogen atmosphere for 8 hours. After the reaction was finished, 0.5 g of hydroquinone was added to the reaction mixture and the solvent was distilled away under reduced pressure. When the mixture became viscous, the polymer mixture was poured onto a stainless steel plate and dried in vacuo. Thus 270 g of resin (Polymer No. 1) in the form of a plate was obtained. The measured GPC value of the polymer was as follows.

Mw: $4.80 \times 10^4$, dispersion ratio: 2.2

[Synthesis of Polymer No. 2]

To a mixture of 190 ml of rectified acetone and 190 ml of rectified methanol, 49.6 g of N-(4-hydroxyphenyl)methacrylamide, 36.1 g of acrylonitrile, 17.2 g of methyl methacrylate (the total monomer concentration: 5.3 moles/ℓ) were dissolved and 12 g (3.7 moles) of azoisobutyronitrile was added to allow polymerization of the monomers in a nitrogen atmosphere under refluxing for 8 hours. After the reaction was finished, the reaction mixture was poured into water and thus 168 g of white resin (Polymer No. 2) was separated. The GPC value measured with respect to the obtained polymer was as follows.

Mw: $2.4 \times 10^4$, Dispersion ratio: 2.1

Example 1

A defatted and washed aluminum plate was anodized in a 40 wt.% sulfuric acid aqueous solution with 1.5 A/dm$^2$ current at 30°C for 2 minutes. The anodized plate was washed with water and treated with a 1 wt.% sodium silicate at 85°C for 25 sec. Thus Support No. 1 was obtained.

The following primer composition was applied on the surface of Support No. 1 at 55°C and the support was dried at 85°C for 3 minutes. The thickness of the dry film was 10 mg/cm$^2$.

<u>Primer Composition</u>

| | |
|---|---|
| Polymer No. 1 (polymer containing alcoholic hydroxyl groups) | 100 parts |
| Diazo Resin No. 1 (p-diazodiphenylamine-formaldehyde resin) | 20 parts |
| Methyl cellosolve | 2400 parts |

The entire surface of the thus coated plate was exposed to light from a 3 KW super high pressure mercury lamp at 1000 mJ/cm$^2$. The thus obtained aluminum plate bearing a primer layer was immersed in a solvent for

the photosensitive layer (methyl cellosolve) and the primer layer did not dissolve.

The rate of diazo decomposition was determined by measuring UV integral sphere using Hitachi Spectrophotometer 3200. It was proved that the diazo absorption band at 378 nm was entirely decomposed.

On the primer layer provided on the aluminum support, the following photosensitive composition was applied to the dry thickness of 3 mg/dm$^2$ at 55°C by means of a whirling coater and dried. Thus a photosensitive layer was formed.

Photosensitive Composition

| | |
|---|---|
| Polymer No. 1 (a polymer containing alcoholic hydroxyl groups) | 100 parts |
| Diazo Resin No. 1 (p-diazodiphenylamine-formaldehyde resin) | 10 parts |
| Victorian blue BOH | 2 parts |
| Methyl cellosolve | 2000 parts |
| Ethyl cellosolve | 1000 parts |

Then, on the above-described photosensitive layer, the following silicone rubber composition was applied to a thickness of 15 mg/dm$^2$ in the dry condition at 55°C by means of a whirling coater and dried. Thus a silicone layer was formed.

Silicone Rubber Composition

| | |
|---|---|
| YF-3057 (supplied by Toshiba Silicone K.K.) | 100 parts |
| TSL-8180 (supplied by Toshiba Silicone K.K.) | 10 parts |
| Aerosil R-972 (supplied by Nippon Aerosil K.K.) | 3 parts |
| Dibutyltin dilaurate | 0.8 part |
| Hexane | 1400 parts |

Over the thus formed silicone rubber layer, a polypropylene film having a thickness of 5 μ, one side of which had been matted, was laminated and thus a waterless lithographic printing plate was obtained. A positive film was laid on this printing plate and the plate was exposed to light from a 3 KW super high pressure mercury lamp at 100 mJ/cm$^2$. Thereafter, the laminated film was peeled off and the plate was immersed in the following developer for 1 minute and rubbed with a developing pad to remove the silicone rubber and unexposed photosensitive layer. The photosensitive layer was colored with the dye, while the primer layer was not dyed. Therefore, the end point of the developing, at which the photosensitive layer was completely removed and the primer layer appeared, was visually observed.

Developer

| | |
|---|---|
| Isopar H (supplied by Esso Chemicals) | 35 parts |
| Diethyl succinate | 5 parts |
| Polypropylene glycol | 5 parts |
| Phenyl cellosolve | 5 parts |
| Diethanolamine | 2 parts |
| Pionine A-44B (Takemoto Yushi K.K.) | 3 parts |
| Water | 45 parts |

The thus developed printing plate was lightly wiped with a cloth which was dipped in the following dyeing solution and rinsed. A bright purple positive image appeared.

Dyeing Solution

| | |
|---|---|
| Crystal violet | 0.5 part |
| Ethanol | 50 parts |
| Water | 150 parts |

The thus prepared printing plate was mounted on the Heidel GTO (manufactured by Heidel GmbH), from which the wetting-water supply device had been removed, and printing was carried out using Aqualess Five Black TPM ink supplied by Toyo Ink Seizo K.K.. More than 20,000 sheets of good prints free from staining in the non-image portion were obtained.

Example 2

The non-image portion of the printing plate prepared in Example 1 was scratched by a continuous loading scratch strength tester Type HEIDON-18 manufactured by Shinto Kagaku K.K. with a sapphire stylus having the diameter of 0.4 mm under a load of 300 g. The thus treated printing plate was used for printing. Stains in line with the scratch did not appear in printed sheets.

Example 3

The procedures of Example 1 were repeated using Polymer No. 2 (polymer containing phenolic hydroxyl groups) instead of Polymer No. 1 (polymer containing alcoholic hydroxyl groups) and a printing plate was obtained and used for printing. More than 10,000 good printed sheets free from stain were obtained.

Comparative Example 1

On the surface of a support prepared in accordance with Example 1, a primer layer was formed by applying a primer layer composition (a photodimerization type photocurable resin) as indicated below to a thickness of 5 $mg/dm^2$ in the dry state and the plate was exposed to light from a 3 KW super high pressure mercury lamp at 1000 $mJ/cm^2$.

Primer Layer Composition

| | |
|---|---|
| A photosensitive unsaturated polyester obtained by 1:1 polycondensation of p-phenylene diacrylate and 1,4-dihydroxyethyl cyclohexane | 10 parts by weight |
| 1-Methyl-2-benzoylmethylene | 0.6 part by weight |
| KBM-603 (N-β-(aminoethyl)-γ-aminopropyltrimethoxysilane, silane coupler marketed by Shin'etsu Kagaku K.K.) | 0.5 part by weight |
| Methyl cellosolve acetate | 150 parts by weight |
| Toluene | 150 parts by weight |
| Methyl cellosolve | 150 parts by weight |

On this primer layer the same photosensitive layer and silicone rubber layer as those of Example 1 were formed and further a propylene film was laminated on the silicone rubber layer. Thus a waterless lithographic printing plate was obtained.

The printing plate was exposed and developed in the same manner as in Example 1. The surface of the printing plate was strongly rubbed with a piece of cloth wetted with a dyeing solution. But the printing plate was not dyed and checking of the formation of image was difficult.

Comparative Example 2

The procedures of Comparative Example 1 were repeated and a primer layer having a thickness of 6 μ was formed on the support, and exposed to light from a 3 KW super high pressure mercury lamp at 2000 $mJ/cm^2$.

A photosensitive layer, a silicone rubber layer were formed and lamination was carried out in the same manner as in Example 1. The thus obtained waterless lithographic printing plate was exposed and developed in the same manner.

The plate was scratched in the same manner as in Example 2 with a load of 300 g and used for printing. Scar-like stain appeared.

As has been described in detail, the present invention overcomes defects of the prior art and provides a waterless photosensitive lithographic printing plate which has excellent dyeability and excellent adhesion of the support and the photosensitive layer.

## Claims

1. A photosensitive lithographic printing plate requiring no wetting water, which comprises a support and at least a primer layer, a photosensitive layer and a silicone rubber layer provided on the support in this order, said primer layer containing at least a diazo resin and a hydroxyl group-containing polymer and having been photochemically cured before the photosensitive layer is applied.

2. The photosensitive lithographic printing plate as recited in Claim 1, wherein said hydroxyl-group-containing polymer contains alcoholic-hydroxyl groups.

3. The photosensitive lithographic printing plate as recited in Claim 1 or 2, wherein the content of the hydroxyl-group-containing polymer in the primer layer is 10-99 wt.%.

4. The photosensitive lithographic printing plate as recited in any of Claims 1-3, wherein the content of the hydroxyl-group-containing polymer in the primer layer is 40-97 wt.%.

5. The photosensitive lithographic printing plate as recited in any of Claims 1-4, wherein the content of the diazo resin in the primer layer is 1-90 wt.%.

6. The photosensitive lithographic printing plate as recited in any of Claims 1-5, wherein the content of the diazo resin in the primer layer is 3-60 wt.%.

7. The photosensitive lithographic printing plate as recited in any of Claims 1-6, wherein the content of the hydroxyl-group-containing monomers in the hydroxyl-group-containing polymer is 5-100 wt.%.

8. The photosensitive lithographic printing plate as recited in any of Claims 1-7, wherein the content of the hydroxyl-group-containing monomers in the hydroxyl-group-containing polymer is 20-100 wt.%.

9. The photosensitive lithographic printing plate as recited in any of Claims 1-8, wherein the weight average molecular weight of the hydroxyl-group-containing polymer measured by GPC with styrene as reference is 5,000-1,000,000.

10. The photosensitive lithographic printing plate as recited in any of Claims 1-9, wherein the content ratio of the diazo resin and the hydroxyl-group-containing polymer is 1/99 - 90/10.

## Patentansprüche

1. Lichtempfindliche lithographische Druckplatte, welche kein Befeuchtungswasser benötigt, umfassend einen Träger und mindestens eine Primerschicht, eine lichtempfindliche Schicht und eine Siliconkautschukschicht, welche auf dem Träger in dieser Reihenfolge vorgesehen sind, wobei die Primerschicht mindestens ein Diazoharz und ein hydroxylgruppenhaltiges Polymer enthält und vor Aufbringung der lichtempfindlichen Schicht photochemisch gehärtet worden ist.

2. Lichtempfindliche lithographische Druckplatte nach Anspruch 1, wobei das hydroxylgruppenhaltige Polymer alkoholische Hydroxylgruppen enthält.

3. Lichtempfindliche lithographische Druckplatte nach Anspruch 1 oder 2, wobei der Gehalt des hydroxylgruppenhaltigen Polymeren in der Primerschicht 10-99 Gew.-% beträgt.

4. Lichtempfindliche lithographische Druckplatte nach mindestens einem der Ansprüche 1-3, wobei der Gehalt des hydroxylgruppenhaltigen Polymeren in der Primerschicht 40-97 Gew.-% beträgt.

5. Lichtempfindliche lithographische Druckplatte nach mindestens einem der Ansprüche 1-4, wobei der Gehalt des Diazoharzes in der Primerschicht 1-90 Gew.-% beträgt.

6. Lichtempfindliche lithographische Druckplatte nach mindestens einem der Ansprüche 1-5, wobei der Gehalt des Diazoharzes in der Primerschicht 3-60 Gew.-% beträgt.

7. Lichtempfindliche lithographische Druckplatte nach mindestens einem der Ansprüche 1-6, wobei der Gehalt der hydroxylgruppenhaltigen Monomeren in dem hydroxylgruppenhaltigen Polymer 5-100 Gew.-% beträgt.

8. Lichtempfindliche lithographische Druckplatte nach mindestens einem der Ansprüche 1-7, wobei der Gehalt der hydroxylgruppenhaltigen Monomeren in dem hydroxylgruppenhaltigen Polymer 20-100 Gew.-% beträgt.

9. Lichtempfindliche lithographische Druckplatte nach mindetens einem der Ansprüche 1-8, wobei das durch GPC mit Styrol als Referenz gemessene, gewichtsmittlere Molekulargewicht des hydroxylgruppenhaltigen Polymeren 5 000-1 000 000 beträgt.

10. Lichtempfindliche lithographische Druckplatte nach mindestens einem der Ansprüche 1-9, wobei das Mengenverhältnis des Diazoharzes und des hydroxylgruppenhaltigen Polymeren 1/99-90/10 beträgt.

## Revendications

1. Plaque d'impression lithographique photosensible ne nécessitant pas d'eau de mouillage, qui comprend un support et au moins une couche primaire, une couche photosensible et une couche de caoutchouc silicone disposées sur le support dans cet ordre, ladite couche primaire contenant au moins une résine diazoïque et un polymère contenant des groupes hydroxyle et ayant été réticulée par voie photochimique avant que la couche photosensible ne soit appliquée.

2. Plaque d'impression lithographique photosensible selon la revendication 1, dans laquelle ledit polymère contenant des groupes hydroxyle contient des groupes hydroxyle alcooliques.

3. Plaque d'impression lithographique photosensible selon la revendication 1 ou 2, dans laquelle la teneur en polymère contenant des groupes hydroxyle dans la couche primaire est de 10 à 99% en poids.

4. Plaque d'impression lithographique photosensible selon l'une quelconque des revendications 1 à 3, dans laquelle la teneur en polymère contenant des groupes hydroxyle dans la couche primaire est de 40 à 97% en poids.

5. Plaque d'impression lithographique photosensible selon l'une quelconque des revendications 1 à 4, dans laquelle la teneur en résine diazoïque dans la couche primaire est de 1 à 90% en poids.

6. Plaque d'impression lithographique photosensible selon l'une quelconque des revendications 1 à 5, dans laquelle la teneur en résine diazoïque dans la couche primaire est de 3 à 60% en poids.

7. Plaque d'impression lithographique photosensible selon l'une quelconque des revendications 1 à 6, dans laquelle la teneur en monomères contenant des groupes hydroxyle dans le polymère contenant des groupes hydroxyle est de 5 à 100% en poids.

8. Plaque d'impression lithographique photosensible selon l'une quelconque des revendications 1 à 7, dans laquelle la teneur en monomères contenant des groupes hydroxyle dans le polymère contenant des groupes hydroxyle est de 20 à 100% en poids.

9. Plaque d'impression lithographique photosensible selon l'une quelconque des revendications 1 à 8, dans laquelle le poids moléculaire moyen en poids du polymère contenant des groupes hydroxyle, mesuré par CPG (chromatographie par perméation de gel) avec du styrène comme référence, est de 5000 à 1.000.000.

10. Plaque d'impression lithographique photosensible selon l'une quelconque des revendications 1 à 9, dans laquelle le rapport de la teneur en résine diazoïque à la teneur en polymère contenant des groupes hydroxyle est de 1/99 à 90/10.